# EUROPEAN PATENT SPECIFICATION

(11) **EP 3 216 837 B1**
(45) Date of publication and mention of the grant of the patent: **15.07.2020**
(21) Application number: 16780036.6
(22) Date of filing: 12.04.2016
(51) Int. Cl.: C09J 9/02, C09J 7/30, C09J 11/04, C09J 163/00, C09J 179/04, C09J 201/00, H01L 21/52, C08K 3/08, C08K 5/00

(54) **ELECTRICALLY CONDUCTIVE ADHESIVE FILM AND DICING DIE BONDING FILM**
ELEKTRISCH LEITENDE HAFTFOLIE UND VEREINZELNDE CHIP-BONDING-FOLIE
FILM ADHÉSIF ÉLECTROCONDUCTEUR ET FILM DE DÉCOUPAGE/FIXATION DE PUCES

(30) Priority: 16.04.2015 JP 2015084094
(43) Date of publication of application: 13.09.2017
(73) Proprietor: Furukawa Electric Co., Ltd., Chiyoda-ku Tokyo 100-8322 (JP)
(72) Inventor: MIHARA, Naoaki, Tokyo 100-8322 (JP); KIRIKAE, Noriyuki, Tokyo 100-8322 (JP); SUGIYAMA, Jirou, Tokyo 100-8322 (JP)
(74) Representative: Goddar, Heinz J.
(86) International application number: PCT/JP2016/061795
(87) International publication number: WO 2016/167245

(56) References cited:
- WO-A1-2012/118061
- WO-A1-2013/146604
- WO-A1-2013/146604
- WO-A1-2014/002893
- WO-A1-2016/031552
- JP-A- 2001 303 015
- JP-A- 2001 303 015
- JP-A- 2001 332 137
- JP-A- 2002 161 146
- JP-A- 2007 250 540
- JP-A- 2013 152 867
- JP-A- 2014 084 357
- JP-A- 2014 143 390
- US-A1- 2004 225 026
- US-B1- 7 851 930

## Description

### TECHNICAL FIELD

The present invention relates to an electrically conductive adhesive film and a dicing die bonding film that is obtained by bonding a pressure-sensitive adhesive tape thereto.

### Background Art

Conventionally, when bonding semiconductor power devices such as IGBT and MOS-FET on to metal lead frames, lead-free solder has been widely used; however, in recent years, the toxicity of lead is being considered problematic.

Further, in recent years, due to the growing requirements for higher-density energy control, studies on power devices that utilize wide-gap semiconductors such as SiC and GaN, which show resistance at junction temperatures of 200 °C or higher, are moving along. However, because the eutectic melting point of lead solder is low, the lack of heat resistance at the joint has been an obstacle.

In accordance with the above background, various types of lead-free solders that do not contain lead have appeared. Among such lead-free solders, high-melting point solder such as AuGe is attracting attention as a bonding material for wide-gap semiconductor devices (Patent Document 1). However, the high price of the material and the increase in mounting temperature causes the process cost to increase, thus, hindering its popularization. Further, since most lead-free solders exhibit lower wettability than lead solder, the solder does not spread on the die pad part, causing parts of the die such as the corner to lack solder. Thus, the risk of bonding defects occurring at such corner is a problem. Since the wettability of lead-free solder tends to deteriorate with the increase in melting point, it is difficult to achieve both heat resistance and mounting reliability.

In order to solve the above problem, studies on diffusive sintering-type solder, such as Cu/Sn-based solder, is underway. Although such diffusive sintering-type solders show low melting point at mounting, since the melting point increases irreversibly after the diffusive sintering reaction, it is more advantageous than conventional lead-free solders in achieving both heat resistance and mounting reliability. However, even in diffusive sintering-type solders, because the wettability is slightly inferior than lead solder, for the bonding of large-area devices such as those of 5mm x 5 mm or more, there is still the risk of lacking solder. Further, since the sintered body is hard and brittle, and exhibit low stress relaxation property, which causes low heat-resisting fatigue property, there is the disadvantage of shorter device life.

Other than the above-described lead-free solder, Ag pastes are being used, but the drastic increase in material cost and contamination by the migration of Ag ion are seen as problems.

Further, in general, many lead solders and lead-free solders often contain flux such as pine resin and alcohol for the purpose of removing metal oxide films (Patent Document 3). However, such flux components tend to bleed out after moisture absorption. Further, since the removability of metal oxide films of such conventional flux is not very high, it is necessary to add them in large amounts, causing the amount of bleed-out to become extensive, which is known to have adverse effect on the anti-reflow reliability of the bonding of semiconductor devices. Conventionally, flux rinsing was said to be necessary after soldering, but such labor and the processing of waste fluid is becoming problematic. Nevertheless, if the addition amount of the flux is reduced to decrease bleed-out, the oxide film removability becomes insufficient, causing appearance of electric conductivity and other properties to be difficult.

### RELATED ART

### Patent Documents

Patent Document 1: JP2002-A-307188
Patent Document 2: JP2007-A-152385
Patent Document 3: US2014/120356 A1
Patent Document 4: US7851930A1.

### SUMMARY

The purpose of the present invention is to provide a means that exhibit excellent heat resistance and mounting reliability, when bonding a semiconductor power device on to a metal lead frame, which is also lead-free and places little burden on the environment.

As a result of keen investigation, the applicants arrived at the invention of an electrically conductive adhesive film that solves the above-described problems.

That is, the present invention relates to an electrically conductive adhesive film, which comprises metal particles, a thermosetting resin, and a compound having Lewis acidity or a thermal acid generator, wherein the compound having Lewis acidity or the thermal acid generator is selected from: boron fluoride or a complex thereof, a protonic acid with a pKa value of -0.4 or lower, or a salt or acid obtained by combining an anion that is the same as the salt of the protonic acid with a pKa value of -0.4 or lower with hydrogen ion or any other cation, wherein the thermosetting resin contains a maleic imide resin that contains two or more units of imide groups in one molecule, and comprises structures derived from aliphatic amines of C30 or more with structures of a formula (1).

Further, it is preferable that the compound having Lewis acidity or thermal acid generator contains less than 0.1 wt% of antimony and arsenic in total.

Further, it is preferable that the compound having Lewis acidity or thermal acid generator is selected from: boron fluoride or a complex thereof; fluoroborate salt, polyfluoroalkyl boronic acid or a salt thereof; polyfluoroaryl boronic acid, polyfluoroalkyl fluorophosphoric acid or a salt thereof; or polyfluoroaryl fluorophosphoric acid or a salt thereof.

Further, it is preferable that the compound having Lewis acidity or thermal acid generator is selected from a salt of aryl sulfonium cation, or a salt of aryl iodonium cation.

Furthermore, it is preferable that the weight ratio of the compound having Lewis acidity or thermal acid generator is 0.3 to 3 wt% and the weight ratio of the metal particles is 70 to 96 wt% in the electrically conductive adhesive film.

Further, it is preferable that the boiling point or sublimation point of the compound having Lewis acidity or thermal acid generator is 200 °C or higher under normal pressure.

Furthermore, it is preferable that the total amount of lead, mercury, antimony, and arsenic in the electrically conductive adhesive film is less than 0.1 wt%.

Further, it is preferable that at least part of the metal particles contains any one of Cu, Ni, or Sn.

Further, it is preferable that the metal particles are a mixture of two or more metals, which contains a combination that is mutually capable of forming an intermetallic compound.

Further, it is preferable that at least two metals in the two or more metals are selected from Cu, Ag, Ni, Ti, Al, Sn, Zn, Au, and In.

Moreover, it is preferable that when observed by DSC (Differential Scanning Calorimetry), at least one endothermic peak exists at 100 °C to 250 °C prior to sintering, which is not observed after sintering.

In addition, the present invention relates to a dicing die bonding film, which is obtained by bonding the electrically conductive adhesive film with a pressure-sensitive adhesive tape.

### Effect of the Invention

By using the electrically conductive adhesive film provided by the present invention or the dicing die bonding film obtained by bonding it with a pressure-sensitive adhesive tape, an inexpensive means that places little burden on the environment for electrically bonding power semiconductors on to metal lead frames etc., is achieved. The means exhibits excellent heat resistance after sintering while enabling mounting at low temperature, does not cause solder-lacking defects, and shows excellent thermal fatigue resistance and reflow-resistance after moisture absorption, even without a flux-rinsing process.

### BRIEF DESCRIPTION OF DRAWINGS

[FIG. 1] FIG. 1 is a sectional scheme of an embodiment of the dicing die bonding film of the present invention.
[FIG. 2] FIG. 2 is a scheme that shows a state in which the dicing die bonding film of the present invention is affixed on to a semiconductor.
[FIG. 3] FIG. 3 is a scheme that describes the dicing process.
[FIG. 4] FIG. 4 is a scheme that describes the pickup process.
[FIG. 5] FIG. 5 is a scheme that describes the die bonding process.
[FIG. 6] FIG. 6 is a scheme that shows the sectional view of a molded semiconductor device.
[FIG. 7] FIG. 7 is a scheme that shows the molar absorptivity coefficient spectrum of each acid.

### DESCRIPTION OF SOME EMBODIMENTS

The electrically conductive adhesive film of the present invention comprises metal particles, a thermosetting resin, and a compound having Lewis acidity or a thermal acid generator.

The metal particles are responsible for the electric conductivity and thermal conductivity, while the thermosetting resin is responsible for film-formation prior to sintering and adding alleviative property against stress that occurs from the heat cycle after sintering. The compound having Lewis acidity or the thermal acid generator functions as the so-called "flux" by removing the oxide film on the surface of the metal particles, thereby assisting in their function.

### (Metal Particles)

It is preferable that at least part of the metal particles in the present invention contain a combination that is mutually capable of forming an intermetallic compound, from the viewpoint of exerting heat resistance to temperatures higher than the mounting temperature after sintering, while decreasing the mounting temperature.

As the combination of metals that can form intermetallic compounds, for example, the combination of Cu or Ni or Ag with Sn or Zn, the combination of Ag and Sn, the combination of Ni or Sn or A1 with Ti, the combination of Au and In, etc., may be listed. However, in particular, from the viewpoint of lowering the mounting temperature, combinations that contain Sn, which has a low melting point, is preferable, and the combination of Cu or Ni with Sn is especially preferable.

In addition to the aforementioned combination of metals that enable the formation of intermetallic compounds, other metal components may be added as required. For example, by adding Zn, Bi, Ag, In, Ga, Pd, etc. to Sn, alloying beforehand and using particles thereof, the melting point may further be lowered.

The weight ratio of the metal particles in the electrically conductive adhesive film is preferably 70 to 96 wt%. (Note that in the present case, "the adhesive film" does not contain the weight of the substrate such as PET. The same applies hereinafter.)

The metal particles contain as little lead, mercury, antimony and arsenic as possible. Specifically, from the point of low environmental burden, it is preferable that their content in the electrically conductive adhesive film is less than 0.1 wt%.

Prior to the later-described sintering after dicing, by having a melting point that can be assigned to at least one metal component, which is observed as an endothermic peak by DSC, the content becomes spreadable on to the surface of the adherend, thus, making mounting at low temperature advantageous. Further, after sintering, the component undergoes intermetallic diffusion reaction, causing the melting point to rise. Thus, sufficient heat resistance is obtained, even when, for example, subjected to a wire bonding process by a high-melting point lead-free solder, or to a reflow process. The mounting temperature is preferably 100 to 250 °C, and more preferably, is 100 to 200 °C. The heat resistance is preferably 250 °C or higher, and more preferably, is 300 °C or higher.

### (Thermosetting Resin)

From the viewpoint of heat resistance and film formation when the metal particles are mixed, the thermosetting resin contains a maleic imide resin (maleimide resin) that contains two or more units of imide groups in one molecule. The maleic imide resin can be obtained by, for example, subjecting maleic acid or an anhydride thereof and diamine or polyamine to condensation. However, from the viewpoint of stress relaxation, those comprise structures derived from aliphatic amines of C30 or more with structures as shown in the following formula (1).

### Formula (1)

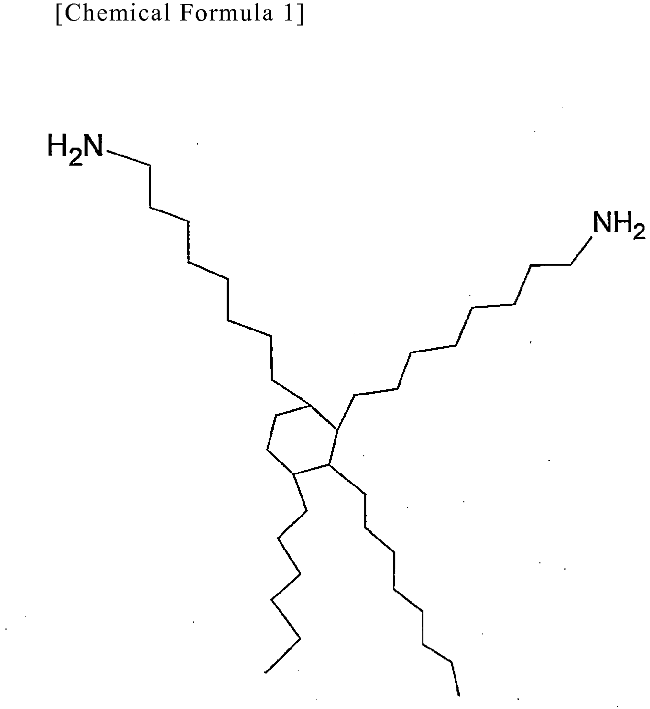

The maleic acid imide resin may contain acid components other than maleic acid, such as structures derived from benzene tetracarboxylic acid or an anhydride thereof, hydroxyphthalic acid bis(ether) or an anhydride thereof, etc., in order to adjust the molecular weight or Tg. As the curing agent for the maleic acid imide resin, phenol resins, radical generators, etc., are preferable.

As a bismaleimide resin of such structure, for example, those shown in the following structural formula may be listed.

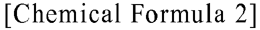

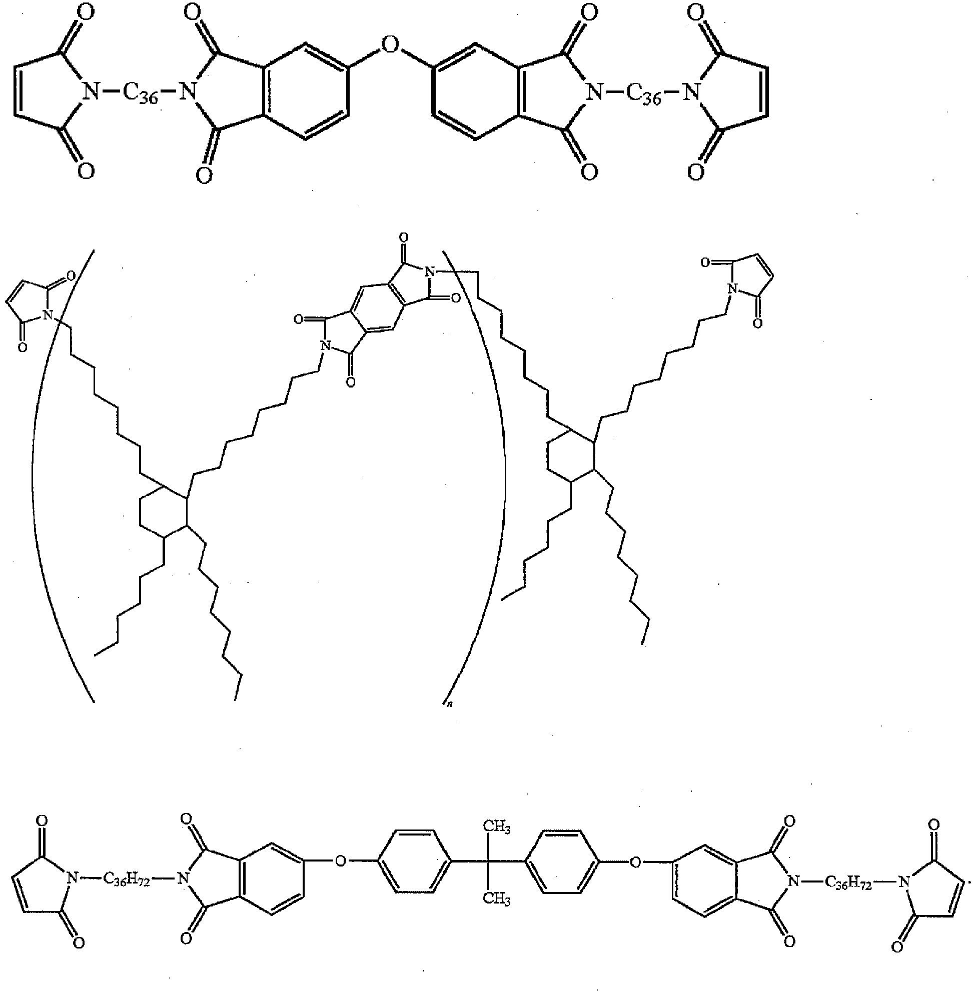

Note that in the above formula, "C₃₆" refers to the following structure.

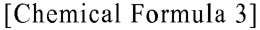

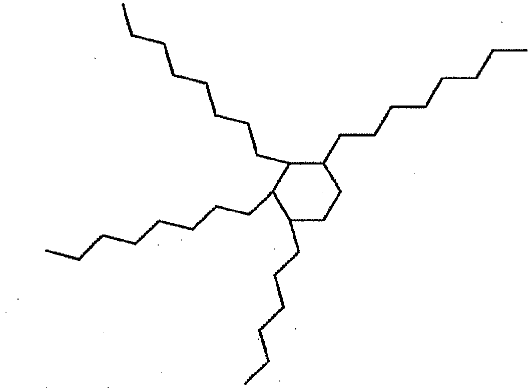

By containing such thermosetting resins that possess stress relaxation properties, the sintered body of the electric conductive adhesive film of the present invention overcomes the disadvantages of conventional metal-only lead-free solders, which were hard and brittle, and thus showed poor thermal fatigue properties, and secure film-formation property prior to sintering.

### (Compound having Lewis Acidity or Thermal Acid Generator)

Since the compound having Lewis acidity or thermal acid generator is i) boron fluoride or a complex thereof, ii) a protonic acid with a pKa value of -0.4 or lower, or iii) a salt or acid obtained by combining an anion that is the same as the salt of the protonic acid with a pKa value of -0.4 or lower with hydrogen ion or any other cation, the removability of metal oxide film is far greater, compared to abietic acid and anisic acid with pKa values of about +4 to +5, which have been conventionally used as flux in lead solders and lead-free solders. Thus, the effects are exerted with a much smaller amount than that of conventional flux. Note that a "thermal acid generator" is a compound that exhibits Lewis acidity by heating. It is a material that does not necessarily show strong Lewis acidity at room temperature, but shows strong Lewis acidity when heated. In particular, thermal acid generators that generate protonic acid by hydrogen-withdrawing, when heated to about 80 to 200 °C under the presence of hydrocarbon compounds etc. are favorable, since long-term storage of the material prior to sintering is made possible at an unreacted state with stable physical properties under room temperature, while promptly functioning as a flux when sintered. As such thermal acid generator, for example, a complex obtained by combining boron trifluoride with a Lewis basic compound, and a salt obtained by combining aryl iodonium cation or aryl sulfonium cation with a protonic acid or its salt may be listed.

Here, the acid dissociation constant pKa for fluoboric acid (tetrafluoroboric acid) is -0.4, and protonic acid with a pKa value of -0.4 or lower refers to acids that are stronger than fluoboric acid. Depending on the substance, the value of the acid dissociation constant pKa may not be obtainable, but the relative strength of an acid can be defined by its reactivity. For example, in a state of equilibrium as follows,

A' + A:B ↔ A + A':B

if the reaction greatly proceeds towards the right, A' is a stronger acid than A. From such reactivity, the strength of the acid with reference to fluoboric acid can be determined.

As such a compound having Lewis acidity or thermal acid generator, as the i) boron fluoride or complex thereof, for example, boron trifluoride or an amine complex of boron trifluoride and phenol, pyridine, or bipyridine etc. may be listed. As the above ii) protonic acid with a pKa value of -0.4 or lower, an acid, which is a combination of tetrafluoroborate anion, hexafluorophosphate anion, fluoroantimonate anion, polyfluoroalkyl borate anion, polyfluoroaryl borate anion, or polyfluoroalkylfluoro phosphate anion with proton may be listed. As the cation in the iii) salt or acid obtained by combining an anion that is the same as the salt of the protonic acid with a pKa value of -0.4 or lower with hydrogen ion or any other cation, aryl iodonium cation or aryl sulfonium may be listed. Among these, the complex of boron trifluoride and phenol or amine, a salt obtained by combining tetrafluoroborate anion, hexafluorophosphate anion, fluoroantimonate anion, polyfluoroalkyl borate anion, polyfluoroaryl borate anion, polyfluoroalkylfluoro phosphate anion, or polyfluoroarylfluoro phosphate anion with aryl iodonium cation or aryl sulfonium cation is preferable from the viewpoint of compatibility with thermosetting resin components such as epoxy resin and polyimide resin, and from the viewpoint of preservation stability. Further, fluoroantimonate, polyfluoroalkyl borate, and polyfluoroaryl borate are preferable, since they exhibit high oxide film removability and since most have boiling points or sublimation points of 200 °C or higher under normal pressure; there is little risk of diminishing bonding strength and reliability by forming voids in the adhesive film during sintering. Furthermore, since polyfluoroalkyl borate and polyfluoroaryl borate do not contain antimony, which is highly toxic, they are preferable from the viewpoint of low environmental burden. Also, they are preferable from the viewpoint of film productivity, since they are lipophilic and can easily be dispersed in the thermosetting resin by dissolving in organic solvents.

These compounds having Lewis acidity or thermal acid generators also act as latent curing agents or latent curing catalysts.

The weight ratio of the compound having Lewis acidity or thermal acid generator in the electrically conductive adhesive film is preferably 0.3 to 3 wt%, or more preferably, 0.5 to 1 wt%, from the viewpoint of avoiding the risk of deterioration of reflow reliability after moisture absorption due to bleed-out, while maintaining sufficient metal oxide film removability. Since the amount of the flux component is extremely low, the risk of bleed-out can be diminished without performing a flux-rinsing process, thereby securing sufficient reliability.

The weight ratio of the metal particles is preferably 70 to 96 wt%. By setting the weight ratio of the metal particles to 70 wt% or more, the metal particles come in contact with each other, thus, enabling the volume resistivity to be reduced. Further, by setting the weight ratio of the metal particles to 96 wt% or less, the ability to form a film from the composition, or film formability, is assured.

Since the electrically conductive adhesive film of the present invention is in film form, the adhesive film can be divided along with the wafer in a dicing process, in which the wafer is divided into chips according to each device by, for example, fixing the adhesive film on the backside of a wafer on which power semiconductor device is formed. In this way, the adhesive film is impertinent to problems that arise from liquids, such as the wettability, or in other words, spreading and protrusion of the solder, and thus, can easily be mounted on the entire backside of the device without deficiency or excess. Further, by adjusting the thickness of the adhesive film in advance, the height of the device after die bonding can be controlled with high accuracy, compared to conventional solders and electrically conductive pastes.

Further, by forming a dicing die bonding film by combining the electrically conductive adhesive film of the present invention with a dicing tape, the adhesive film and dicing tape can be bonded on to the wafer at once, and thus, the process can be abbreviated.

The above embodiments will be described with reference to the Figures.

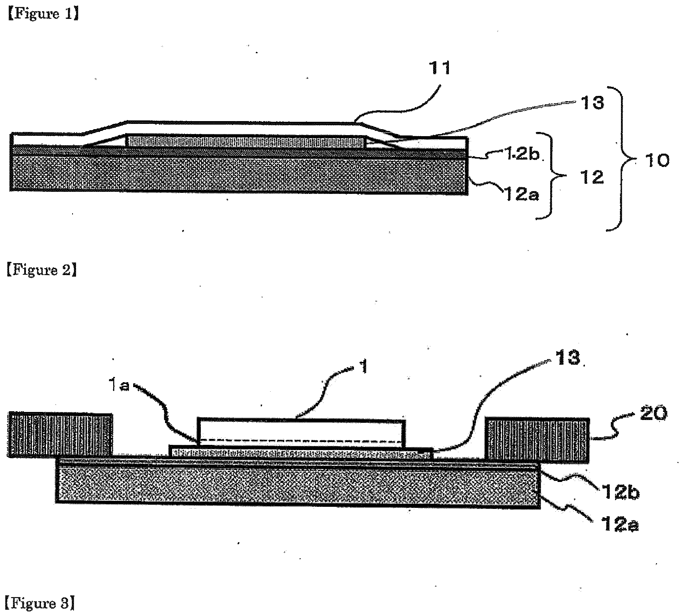

FIG. 1 is a sectional scheme of the dicing die bonding film 10 of the present invention. The dicing die bonding film 10 is mainly composed of a dicing tape 12 and an adhesive film 13. The dicing die bonding film 10 is one example of a semiconductor processing tape, and may be cut (pre-cut) to an arbitrary shape depending on the process or apparatus to be used, or may be cut for each semiconductor wafer, or may be in the form of a long roll.

The dicing tape 12 is composed of a supporting substrate 12a and a pressure-sensitive adhesive layer 12b formed thereon.

The release treated-PET 11 covers the dicing tape 12 and protects the pressure-sensitive adhesive layer 12b and the adhesive film 13.

It is preferable that the supporting substrate 12a is radiolucent. Specifically, plastics and rubbers are normally used, but any material may be used without limitation as long as it has radio lucency.

The base resin composition in the pressure-sensitive adhesive of the pressure-sensitive adhesive layer 12b is not particularly limited, and ordinary radiation-curable pressure-sensitive adhesives may be applied. Preferably, acrylic pressure-sensitive adhesive compositions, which contain functional groups that may react with isocyanate groups, such as a hydroxyl group, are listed. In particular, although not limiting, an acrylic pressure-sensitive adhesive with an iodine value of 30 or lower, which comprises a radiation curable carbon-carbon double bond structure, is preferable.

As for the composition of the adhesive film 13 of the present invention, as described previously, it is extremely favorable that the electrically conductive adhesive film contains metal particles, a thermosetting resin, and a compound having Lewis acidity or a thermal acid generator, since excellent heat resistance and mounting reliability is obtained when bonding the semiconductor power device on to a metal lead frame, and since there is little burden on the environment.

### (Method of Using Dicing Die Bonding Film)

In the production of semiconductor devices, the dicing die bonding film 10 of the present invention may be used favorably.

First, the release-treated PET 11 is removed from the dicing die bonding film 10. Then, as shown in FIG. 2, the adhesive film 13 is affixed on to the semiconductor wafer 1, and the side part of the dicing tape 12 is fixed by the ring frame 20. The ring frame 20 is one example of a frame for dicing. The adhesive film 13 is laminated on to the part of the dicing tape 12 to which the semiconductor wafer 1 is bonded. There is no adhesive film 13 on the part of the dicing tape 12 that comes in contact with the ring frame 20.

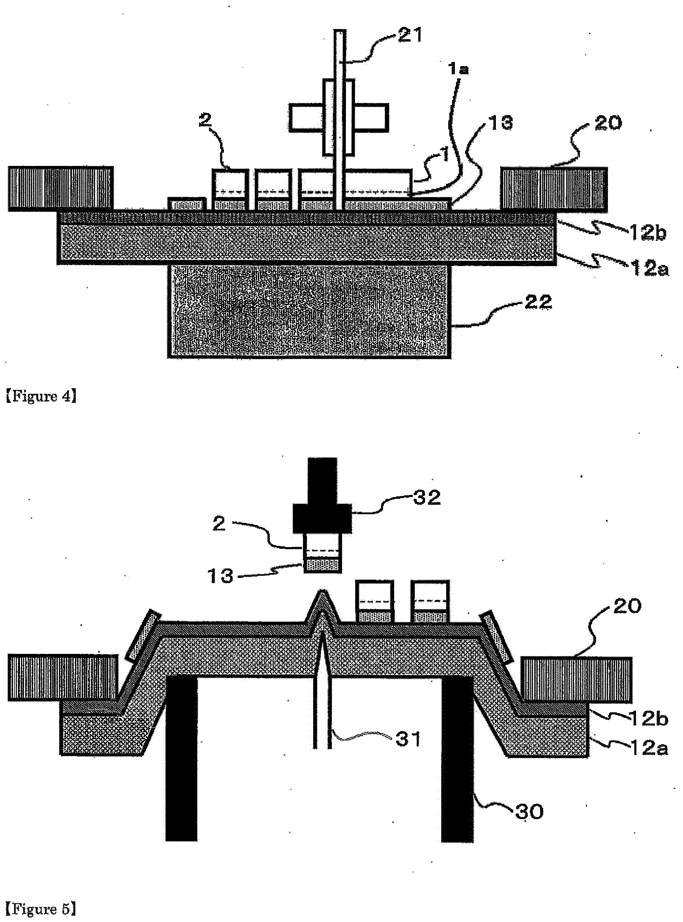

Subsequently, as shown in FIG. 3, the bottom side of the dicing tape 12 is fixed by suction on the suction table 22, while the semiconductor wafer 1 is divided in to a specified size using a dicing blade 21, to produce multiple semiconductor chips 2.

Subsequently, as shown in FIG. 4, while the dicing tape 12 is fixed by the ring frame 20, the tape push-up ring 30 is elevated, thereby bending the center part of the dicing tape 12 in an upward direction, and then irradiating the dicing tape 12 with radiation such as ultra violet ray, to thereby weaken the adhesive strength of the dicing tape 12. Then, the push-up pin 31 is elevated at a position that corresponds to each of the semiconductor chip, to thereby pick up the semiconductor chip 2 by the suction collet 32.

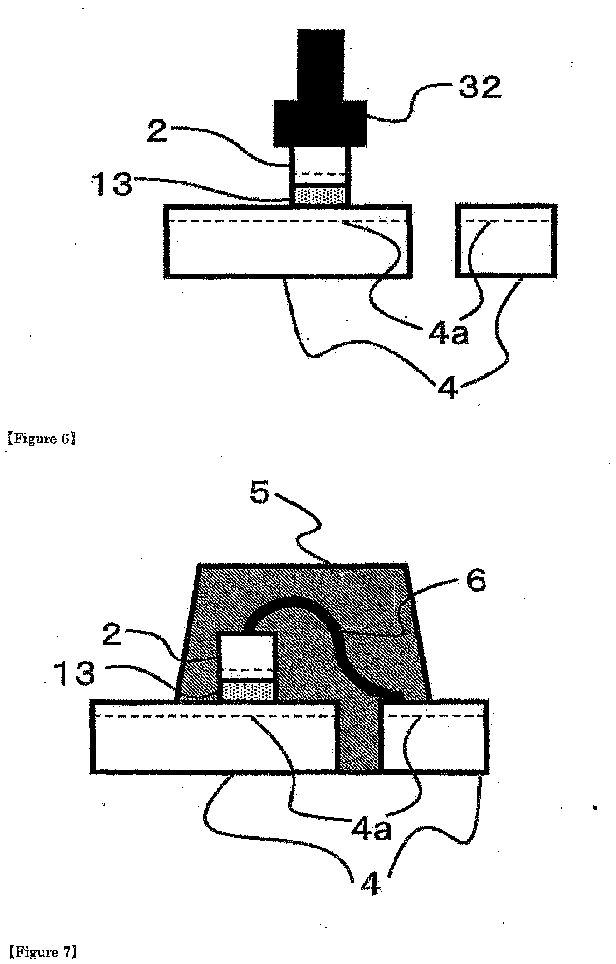

Subsequently, as shown in FIG. 5, the semiconductor chip 2 that was picked up is bonded on to the supporting member such as the lead frame 4 or another semiconductor chip 2 (die bonding process), and as shown in FIG. 6, by undergoing processes such as A1 wire attachment, resin molding, thermosetting, and sintering, a semiconductor device is obtained.

### EXAMPLE

Hereinafter, the present invention will be described more specifically with reference to the Examples. However, the present invention is not limited in anyway by these Examples. Note that wt% indicates percent by weight.

### <Example 5 and Reference Examples 1 to 4, 6 and 7>

To a mixture of 92 wt% of metal particles, 7 wt% of resin, and 1 wt% of compound having Lewis acidity or thermal acid generator (flux), the composition of which is shown in Table 1, toluene was added to form a slurry and subjected to agitation by a planetary mixer. The slurry was then applied thinly on a release-treated PET and subjected to drying at 120 °C, to obtain an adhesive film with a thickness of 40 µm. In Table 1, BMI-3000 refers to the following structure (n = 1 to 10).

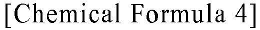

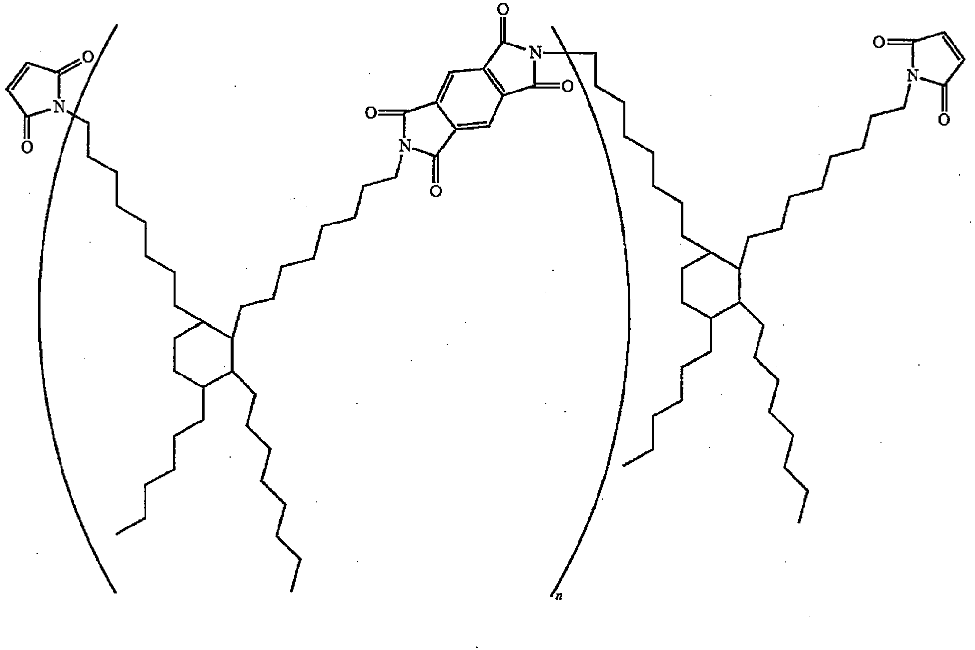

Note that although the pKa values of the acid generators (flux) used in Example 5 and Reference Examples 1 to 4, 6 and 7 are not obtained, whether the pKa values are -0.4 or lower were evaluated by their reactivity against fluoboric acid. The specific method will be described.

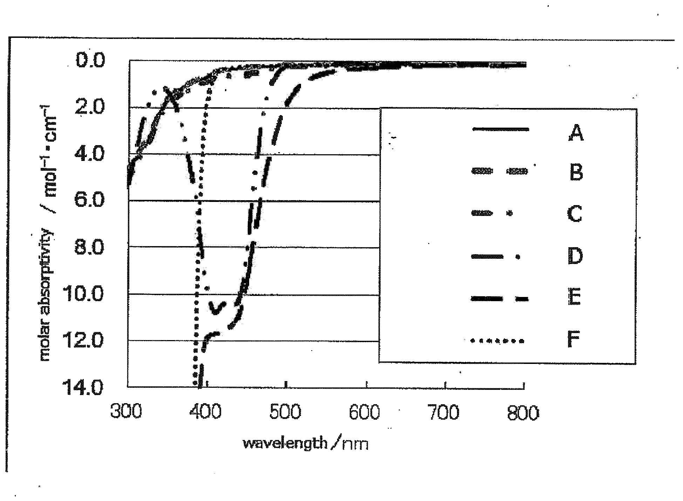

A color reagent (triphenyl methanol) was dissolved in a 1:1 mixed solvent of diethyl ether and 1,2-dichloroethane, to prepare a color reagent solution A. Next, the acids shown in Table 1 were diluted by or dissolved in diethyl ether, to prepare an acid solution B of the same concentration as the aforementioned color reagent solution A. For the mixed solution C obtained by mixing color reagent solution A and acid solution B, the absorbance at 450 nm derived from the triphenylmethylium-formation color reaction resulting from the dehydration of the color reagent triphenyl methanol, as shown in the following reaction formula, was measured using an ultraviolet and visible spectrophotometer (UV-1800, product of Shimadzu Corporation). From the measurement result, the molar absorption coefficient was calculated based on the concentration of the color reagent in the mixed solution C. As shown in Table 1, it was confirmed that the molar absorption coefficient increased when the pKa of the acid was smaller. The molar absorption coefficient spectrum is shown in FIG. 7.

Here, the spectra shown in FIG. 7 refer to the following.
A: triphenyl ethanol only (no acid)
B: valeric acid
C: trichloroacetic acid
D: tetrafluoroboric acid
E: sulfonium salt (heated)
F: sulfonium salt (unheated)

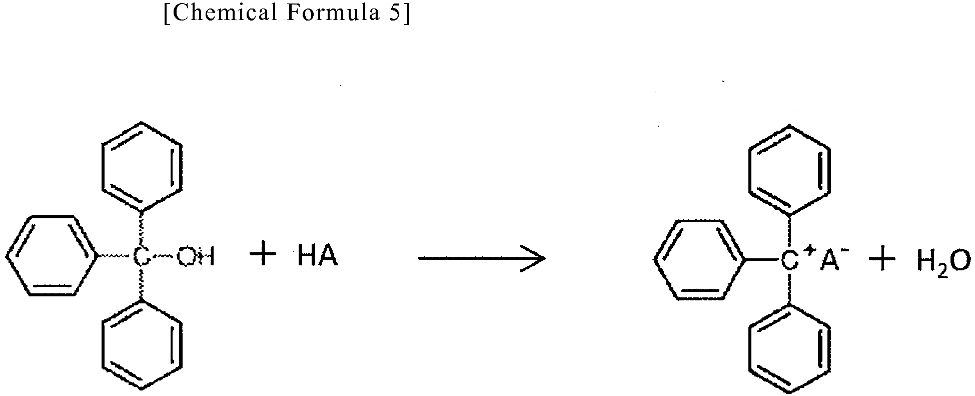

**[Table 1]**

| acid | pKa | molar absorption coefficient @ 450 nm |
|---|---|---|
| valeric acid | 4.8 | 0.27mol-1·cm-1 |
| trichloroacetic acid | 0.7 | 0.54mol-1·cm-1 |
| tetrafluoroboric acid | -0.4 | 8.14mol-1·cm-1 |
| sulfonium salt (heated) | ? | 9.50mol-1·cm-1 |
| sulfonium salt (unheated) | ? | 0.24mol-1·cm-1 |
| triphenyl methanol | - | 0.29mol-1·cm-1 |

Triphenyl methanol was dissolved in 1,4-dioxane to prepare color reagent solution A'. Next, each acid generator of Example 5 and Reference Examples 1 to 4, 6 and 7 and, as the hydrogen source, triphenyl methane were dissolved in toluene or carbonic acid-propionic acid to prepare an acid generator solution B' with the same concentration as that of the aforementioned color reagent solution A'. Then, the solution was subjected to agitation at 100 °C for 1 hour, for acid generation treatment by the hydrogen withdrawing reaction from triphenyl methane to the acid generator. For the mixed solution C' obtained by mixing color reagent solution A' and acid generator solution B', the absorbance at 450 nm derived from the triphenylmethylium-formation color reaction resulting from the dehydration of the color reagent triphenyl methanol was measured using an ultraviolet and visible spectrophotometer (UV-1800 product of Shimadzu Corporation). From the measurement result, the molar absorption coefficient was calculated based on the concentration of the color reagent in the mixed solution C', and by comparing the value with that of tetrafluoroboric acid, which has a pKa value of -0.4, whether the pKa value was smaller or larger was evaluated. Thus, it was confirmed that the pKa values of the acid generators (flux) used in Example 5 and Reference Examples 1 to 4, 6 and 7 were -0.4 or lower.

### <Comparative Examples 1, 2>

Other than changing the composition of Table 2 to 85 wt% of metal particles, 8 wt% of resin, and 7 wt% of flux, adhesive films were produced by the same method as that described in the Examples. Note that the pKa for abietic acid used in Comparative Example 2 is about +4.6.

### <Comparative Example 3>

An adhesive tape was produced by the same method as that of the Examples with the composition shown in Table 2. That is, the amount of abietic acid, which is the flux, in Comparative Example 2 was changed to 1 wt%.

### <Supporting Substrate>

Commercially available resin beads composed of low density polyethylene (Novatec LL, product of Japan Polyethylene Corporation) were melted at 140 °C and formed into a long film with a thickness of 100 µm, using an extruder.

### <Pressure-sensitive Adhesive Composition>

A mixture of n-octyl acrylate, 2-hydroxyethyl acrylate, methacrylic acid, and benzoylperoxide as a polymerization initiator in the ratio of 200:10:5:2 (weight ratio) was dispersed in an appropriate amount of toluene. The reaction temperature and reaction time was adjusted to obtain an acrylic resin solution with a functional group. Next, to this acrylic resin solution, 2 parts by weight of Coronate L (product of Nippon Polyurethane Industry Co., Ltd.) was added as a polyisocyanate for 100 parts by weight of the acrylic resin solution. Further, an appropriate amount of toluene was added as additional solvent and agitated to obtain pressure-sensitive adhesive composition 1.

### <Dicing Tape>

Pressure-sensitive adhesive composition 1 was applied on to the supporting substrate so that the thickness of the pressure-sensitive adhesive composition after drying became 5 µm, which was then subjected to drying at 120 °C for 3 minutes to thereby prepare a dicing tape.

The adhesive tapes obtained in Example 5 and Reference Examples 1 to 4 and Comparative Examples 1 to 3, as well as the dicing tapes obtained by using them, were evaluated for the following items. The results are also shown in Table 2.
- ₊Volume Resistivity ... Measured by the four-point probe method in conformity with JIS-K7194.
- ₊DSC ... The presence or absence (none) of an endothermic peak in the temperature range of 200 to 250 °C were confirmed for the samples before sintering, using a DSC measurement apparatus (DSC 7000, product of Hitachi High-Technologies Corporation).

Next, the same measurement was performed after subjecting each sample to sintering by placing under nitrogen at 250 °C for 4 hours.
- ₊Adhesive Strength ... By bonding the adhesive film with the dicing tape, a die bonding film was prepared. After bonding its backside to a Au-plated Si wafer at 100 °C, and dicing to 5 mm x 5 mm, diced chips with adhesive films were obtained. After die bonding on to a Ag-plated metal lead frame at 140 °C, samples were prepared by sintering at 230 °C for 3 hours. These samples were subjected to a die shear measurement apparatus (4000 series, product of Arctek Corporation) to measure the shear adhesive strength at 260 °C.
- ₊Adhesive Strength After TCT ... The above samples were subjected to thermal cycle testing (TCT) treatment of -40 to 150 °C x 200 times, after which the shear adhesive strength at 260 °C was measured.

PKG Delamination after MSL-Lv1, Lv2 ... The same samples that were used for the measurement of adhesive strength were sealed by an epoxy-based mold resin and subjected to MSL-Lv1, Lv2 treatment of absorption reflow test after moisture absorption in conformity with JEDEC J-STD-020D1 (lead-free solder base), after which they were observed by an ultrasonic image processor (SAT, product of Hitachi Power Solutions, Co. Ltd.) for the development of inner delamination.

**[Table 2]**

| Table 2 | | | | | | | | | | | |
|---|---|---|---|---|---|---|---|---|---|---|---|
| | | Reference | Reference | Reference | Reference | Example 5 | Reference | Reference | Comparative | Comparative | Comparative |
| | | Example 1 | Example 2 | Example 3 | Example 4 | | Example 6 | Example 7 | Example 1 | Example 2 | Example 3 |
| Composition | Metal | Cu | Cu+SnBi alloy | Cu+SnBi alloy | Cu+SnBi alloy | Cu+SnBi alloy | Cu+SnBi alloy | SnAgBiln alloy | Cu+SnBi alloy | Cu+SnBi alloy | Cu+SnBi alloy |
| | Resin | Epoxy | Epoxy | Bismaleimide (C9) | Bismaleimide (C10) | Bismaleimide (C36) | Epoxy | Epoxy | Epoxy | Epoxy | Epoxy |
| | Flux | Lewis Acid (Iodonium) | Lewis Acid (Sulfonium 1) | Lewis Acid (Sulfonium 1) | Lewis Acid (Sulfonium 1) | Lewis Acid (Sulfonium 1) | Lewis Acid (BF₃ Complex) | Lewis Acid (Sulfonium 2) | Tetraethylene Glycol | Abietic Acid | Abietic Acid (1wt%) |
| Evaluation Result | Volume Resistivity µΩ·cm | 2000 | 200 | 50 | 50 | 50 | 800 | 400 | 300 | 700 | > 10000 |
| | Endothermic Peak Befor Sintering | none | 139°C, 230°C | 139°C, 230°C | 139°C, 230°C | 139°C, 230°C | 139°C, 230°C | 210°C | 139°C, 230°C | 139°C, 230°C | 139°C, 230°C |
| | Endothermic Peak After Sintering | none | none | none | none | none | none | 210°C | none | none | 139°C, 230°C |
| | Adhesive Strength (260°C) Mpa | 7,5 | 11 | 8 | 8,2 | 10,2 | 9,5 | < 0.1 | 10 | 10,1 | 4,2 |
| | Adhesive Strength After TCT Mpa | 6 | 8,9 | 7,1 | 10,5 | 12 | 9,1 | < 0.1 | 4 | 3,3 | <0.1 |
| | PKG Pealing After MSL-Lv.1 | observed | none | none | none | none | observed | none | observed | observed | none |
| | PKG Pealing After MSL-Lv.2 | none | none | none | none | none | none | none | observed | observed | none |
| | | | | | | | | | | | |
| | Cu: | Copper Particulates (product of Mitsui Mining and Smelting Co., Ltd.) | | | | | | | | | |
| | SnBi alloy: | Solder Particulates Sn72Bi28 (product of Mitsui Mining and Smelting Co., Ltd.) | | | | | | | | | |
| | SnAgBiIn alloy: | Solder Particulates Sn93Ag3.5Bi0.5h3 (product of Mitsui Mining and Smelting Co., Ltd.) | | | | | | | | | |
| | Epoxy: | 15:5:10:1 mixture of YD-128 + YD-013 + YP-50 (product of Nippon Steel and Sumikin Chemical) + 2PHZ (product of Shikoku Chemicals Corporation) | | | | | | | | | |
| | Bismaleimide C9: | 100:5 mixture of 1,6'-bismaleimide-(2,2,4-trimethyl)hexane + Perbutyl O (product of NOF Corporation) | | | | | | | | | |
| | C10: | 100: 5 mixture of 1,10-bismaleimide-normaldecane + Perbutyl O (product of NOF Corporation) | | | | | | | | | |
| | C36: | 100:5 mixture of BMI-3000 (product of Designer Molecules Inc.) + Perbutyl O (product of NOF Corporation) | | | | | | | | | |
| | Iodonium: | Aryl iodonium polyfluoroalkylfluoro phosphate K-1 (product of San-Apro Inc.) | | | | | | | | | |
| | Sulfonium 1: | Aryl sulfonium polyfluoroalkyl fluoro phosphate TA-100 (product of San-Apro Inc) | | | | | | | | | |
| | Sulfonium 2: | Aryl sufonium hexafluoro phosphate Esacure 1064 (product of Lamberti S.p.A.) | | | | | | | | | |
| | BF₃ Complex: | 3:7 complex of BF₃: Phenol | | | | | | | | | |

**[Table 3]**

| MSL | Moisture Absoption Condition | Reflow Grade Temperature |
|---|---|---|
| Lv. 1 | 85°C-85%RH × 168h | 260 °C |
| Lv.2 | 85°C-60%RH × 168h | 260 °C |

From the above results, it was confirmed that the electrically conductive adhesive films of Example 5 and Reference Examples 1 to 4, 6 and 7, which comprise metal particles, a thermosetting resin, and a compound having Lewis acidity or a thermal acid generator, wherein the pKa value of the compound having Lewis acidity or thermal acid generator is
-0.4 or lower, exert remarkable effects of high heat resistance, high moisture absorption reliability, and high bonding reliability, even though the addition amount of the flux is as small as 1 wt%, without the use of lead solder, which puts a large burden on the environment.

In contrast, in Comparative Example 1, wherein tetraethylene glycol, which is neither a Lewis acid nor a thermal acid generator, was used, and in Comparative Example 2, wherein abietic acid, which is a Lewis acid with a high pKa, was used, showed low adhesive strengths after TCT. Further, since in Comparative Examples 1 and 2, a large amount of flux is used, inner delamination was observed even after the MSL test, confirming that there are problems in moisture absorption reliability and bonding reliability. Further, in Comparative Example 3, wherein the amount of abietic acid was small, as in the Examples, the difference from the Examples of the present invention was even more apparent, showing significantly inferior adhesive strength than the Examples. Further, since abietic acid is a weak acid, the oxide film could not be removed by adding small amounts as in the Examples. Thus, the oxide film became a barrier, and the diffusion reaction between the metals did not proceed, resulting in the endothermic peak to remain even after sintering.

### DESCRIPTION OF NOTATIONS

- 1:: semiconductor wafer
- 1a:: back-side Au plating layer
- 2:: semiconductor chip
- 4:: metal lead frame
- 4a:: Au plating layer
- 5:: mold resin
- 6:: A1 wire
- 10:: dicing die bonding film
- 11:: release-treated PET
- 12:: dicing tape
- 12a:: supporting substrate
- 12b:: pressure-sensitive adhesive layer
- 13:: adhesive film
- 20:: ring frame
- 21:: dicing blade
- 22:: suction stage
- 30:: tape push-up ring
- 31:: push-up pin
- 32:: suction collet

## Claims

1. An electrically conductive adhesive film, which comprises metal particles, a thermosetting resin, and a compound having Lewis acidity or a thermal acid generator, wherein
the compound having Lewis acidity or the thermal acid generator is selected from:
boron fluoride or a complex thereof,
a protonic acid with a pKa value of -0.4 or lower, or
a salt or acid obtained by combining an anion that is the same as the salt of the protonic acid with a pKa value of -0.4 or lower with hydrogen ion or any other cation,
wherein
the thermosetting resin contains a maleic imide resin that contains two or more units of imide groups in one molecule, and comprises structures derived from aliphatic amines of C30 or more with structures of the following formula (1):

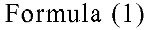

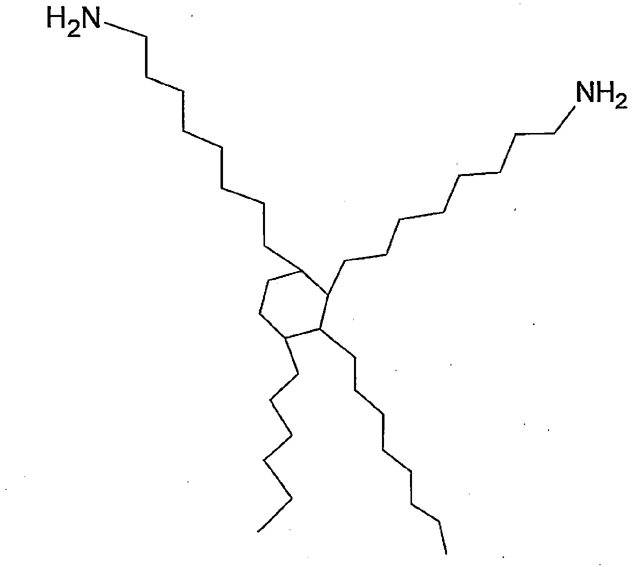

2. The electrically conductive adhesive film of Claim 1, wherein the compound having Lewis acidity or thermal acid generator contains less than 0.1 wt% of antimony and arsenic in total.

3. The electrically conductive adhesive film according to any one of Claims 1 or 2, wherein the compound having Lewis acidity or the thermal acid generator is selected from: boron fluoride or a complex thereof; fluoroborate salt, or polyfluoroalkyl boronic acid or a salt thereof; polyfluoroaryl boronic acid, polyfluoroalkyl fluorophosphoric acid or a salt thereof; or polyfluoroaryl fluorophosphoric acid or a salt thereof.

4. The electrically conductive adhesive film according to any one of Claims 1 or 2, wherein the compound having Lewis acidity or thermal acid generator is selected from a salt of aryl sulfonium cation, or a salt of aryl iodonium cation.

5. The electrically conductive adhesive film according to any one of Claims 1 to 4, wherein the weight ratio of the compound having Lewis acidity or thermal acid generator is 0.3 to 3 wt% and the weight ratio of the metal particles is 70 to 96 wt% in the electrically conductive adhesive film.

6. The electrically conductive adhesive film according to any one of Claims 1 to 5, wherein the boiling point or sublimation point of the compound having Lewis acidity or thermal acid generator is 200°C or higher under normal pressure.

7. The electrically conductive adhesive film according to any one of Claims 1 to 6, wherein the total amount of lead, mercury, antimony, and arsenic is less than 0.1 wt% in the electrically conductive adhesive film.

8. The electrically conductive adhesive film according to any one of Claims 1 to 7, wherein at least part of the metal particles contains any one of Cu, Ni, or Sn.

9. The electrically conductive adhesive film according to any one of Claims 1 to 8, wherein the metal particles are a mixture of two or more metals that contains a combination that is mutually capable of forming an intermetallic compound.

10. The electrically conductive adhesive film according to Claim 9, wherein at least two metals in the two or more metals are selected from Cu, Ag, Ni, Ti, Al, Sn, Zn, Au, and In.

11. The electrically conductive adhesive film according to any one of Claims 1 to 10, which, when observed by DSC (Differential Scanning Calorimetry), has at least one endothermic peak at 100 °C to 250 °C prior to sintering that is not observed after sintering.

12. A dicing die bonding film, which is obtained by bonding the electrically conductive adhesive film of any one of Claims 1 to 11 with a pressure-sensitive adhesive tape.

## Patentansprüche

1. Ein elektrisch leitfähiger Klebstofffilm, der Metallpartikel, ein Duroplast, und eine Verbindung, die eine Azidität nach Lewis oder einen thermischen Säuregenerator aufweist, umfasst, wobei
die Verbindung, die die Azidität nach Lewis oder den thermischen Säuregenerator aufweist, aus Folgendem ausgewählt ist:
Borfluorid oder einem Komplex davon,
einer Protonensäure mit einem pKa-Wert von -0,4 oder weniger, oder
einem Salz oder einer Säure, die durch Kombinieren eines Anions erhalten wird, das das gleiche wie das Salz der Protonensäure mit einem pKa-Wert von -0,4 oder weniger mit Wasserstoffionen oder einem anderen Kation ist,
wobei
das Duroplast ein Maleinimidharz enthält, das zwei oder mehr Einheiten von Imidgruppen in einem Molekül enthält, und Strukturen umfasst, die von aliphatischen Aminen von wenigsten C30 mit Strukturen der folgenden Formel (1) abgeleitet sind:

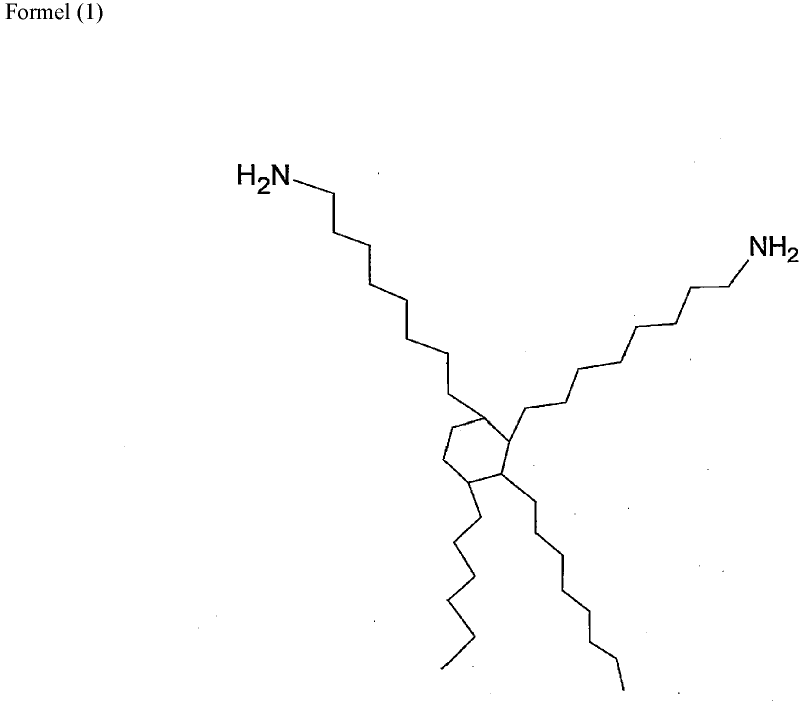

2. Der elektrisch leitfähige Klebstofffilm nach Anspruch 1, wobei die Verbindung, die die Azidität nach Lewis oder den thermischen Säuregenerator aufweist, insgesamt weniger als 0,1 Gew.-% Antimon und Arsen enthält.

3. Der elektrisch leitfähige Klebstofffilm nach einem der Ansprüche 1 oder 2, wobei die Verbindung, die die Azidität nach Lewis oder den thermischen Säuregenerator aufweist, aus Folgendem ausgewählt ist: Borfluorid oder einem Komplex davon; Fluorboratsalz, oder Polyfluoralkylboronsäure oder einem Salz davon; Polyfluorarylboronsäure, Polyfluoralkylfluorphosphorsäure oder einem Salz davon; oder Polyfluorarylfluorphosphorsäure oder einem Salz davon.

4. Der elektrisch leitfähige Klebstofffilm nach einem der Ansprüche 1 oder 2, wobei die Verbindung, die die Azidität nach Lewis oder den thermischen Säuregenerator aufweist, aus einem Salz eines Arylsulfoniumkations oder einem Salz eines Aryliodoniumkations ausgewählt ist.

5. Der elektrisch leitfähige Klebstofffilm nach einem der Ansprüche 1 bis 4, wobei das Gewichtsverhältnis der Verbindung, die die Azidität nach Lewis oder den thermischen Säuregenerator aufweist, 0,3 bis 3 Gew.-% und das Gewichtsverhältnis der Metallpartikel 70 bis 96 Gew.-% in dem elektrisch leitfähigen Klebstofffilm beträgt.

6. Der elektrisch leitfähige Klebstofffilm nach einem der Ansprüche 1 bis 5, wobei der Siedepunkt oder Sublimationspunkt der Verbindung, die die Azidität nach Lewis oder den thermischen Säuregenerator aufweist, unter Normaldruck 200°C oder höher ist.

7. Der elektrisch leitfähige Klebstofffilm nach einem der Ansprüche 1 bis 6, wobei die Gesamtmenge an Blei, Quecksilber, Antimon, und Arsen weniger als 0,1 Gew.-% in dem elektrisch leitfähigen Klebstofffilm beträgt.

8. Der elektrisch leitfähige Klebstofffilm nach einem der Ansprüche 1 bis 7, wobei wenigstens ein Teil der Metallpartikel ein beliebiges von Cu, Ni oder Sn enthält.

9. Der elektrisch leitfähige Klebstofffilm nach einem der Ansprüche 1 bis 8, wobei die Metallpartikel eine Mischung aus zwei oder mehr Metallen sind, die eine Kombination enthält, die gegenseitig in der Lage ist, eine intermetallische Verbindung auszubilden.

10. Der elektrisch leitfähige Klebstofffilm nach Anspruch 9, wobei wenigstens zwei Metalle in den zwei oder mehr Metallen aus Cu, Ag, Ni, Ti, Al, Sn, Zn, Au und In ausgewählt sind.

11. Der elektrisch leitfähige Klebstofffilm nach einem der Ansprüche 1 bis 10, die, wenn durch DSC (Differential-Raster-Kalorimetrie) gemessen, vor dem Sintern wenigstens einen endothermen Peak bei 100 °C bis 250 °C aufweist, der nach dem Sintern nicht gemessen wird.

12. Eine Verbindungsfolie zum Schneiden von Dies, die durch Verbinden des elektrisch leitfähigen Klebstofffilms nach einem der Ansprüche 1 bis 11 mit einem druckempfindlichen Klebeband erhalten wird.

## Revendications

1. Film adhésif électriquement conducteur, qui comprend des particules métalliques, une résine thermodurcissable et un composé ayant une acidité de Lewis ou un générateur d'acide thermique, dans lequel
- le composé ayant une acidité de Lewis ou le générateur d'acide thermique est choisi parmi :
un fluorure de bore ou un de ses complexes,
un acide protonique d'une valeur de pKa inférieure ou égale à -0,4, ou
un sel ou un acide obtenu en combinant un anion qui est le même que le sel de l'acide protonique avec une valeur de pKa de -0,4 ou moins avec l'ion hydrogène ou tout autre cation,
dans lequel
- la résine thermodurcissable contient une résine d'imide maléique qui contient deux unités ou plus de groupes imide dans une molécule, et qui comprend des structures dérivées d'amines aliphatiques de C30 ou plus avec des structures de formule (1) suivante :

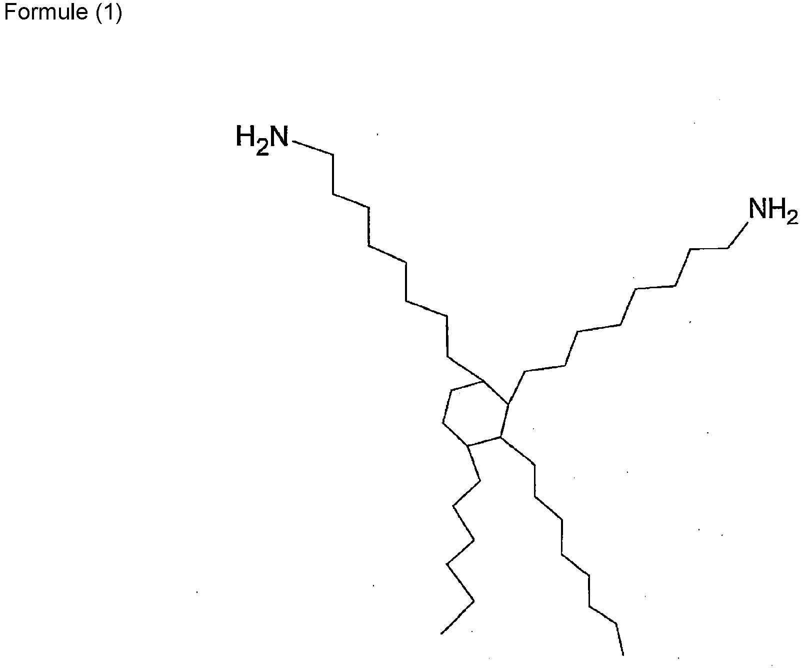

2. Film adhésif électriquement conducteur selon la revendication 1, dans lequel le composé ayant une acidité de Lewis ou un générateur d'acide thermique contient moins de 0,1 % en poids d'antimoine et d'arsenic au total.

3. Film adhésif électriquement conducteur selon l'une quelconque des revendications 1 ou 2, dans lequel le composé ayant l'acidité de Lewis ou le générateur d'acide thermique est choisi parmi : un fluorure de bore ou un complexe de celui-ci ; un sel de fluoroborate, ou l'acide polyfluoroalkyl boronique ou un sel de celui-ci ; l'acide polyfluoroaryl boronique, l'acide polyfluoroalkyl fluorophosphorique ou un de leurs sels ; ou l'acide polyfluoroaryl fluorophosphorique ou un sel de celui-ci.

4. Film adhésif électriquement conducteur selon l'une quelconque des revendications 1 ou 2, dans lequel le composé à acidité de Lewis ou générateur d'acide thermique est choisi parmi un sel de cation aryl sulfonium, ou un sel de cation aryl iodonium.

5. Film adhésif électriquement conducteur selon l'une quelconque des revendications 1 à 4, dans lequel le rapport pondéral du composé ayant une acidité de Lewis ou un générateur d'acide thermique va de 0,3 à 3 % en poids et le rapport pondéral des particules métalliques va de 70 à 96 % en poids dans le film adhésif électriquement conducteur.

6. Film adhésif électriquement conducteur selon l'une quelconque des revendications 1 à 5, dans lequel le point d'ébullition ou le point de sublimation du composé ayant une acidité de Lewis ou un générateur d'acide thermique est de 200 °C ou plus à pression normale.

7. Film adhésif électriquement conducteur selon l'une quelconque des revendications 1 à 6, dans lequel la quantité totale de plomb, de mercure, d'antimoine et d'arsenic est inférieure à 0,1 % en poids dans le film adhésif électriquement conducteur.

8. Film adhésif électriquement conducteur selon l'une quelconque des revendications 1 à 7, dans lequel au moins une partie des particules métalliques contient l'un quelconque parmi Cu, Ni ou Sn.

9. Film adhésif électriquement conducteur selon l'une quelconque des revendications 1 à 8, dans lequel les particules métalliques sont un mélange de deux métaux ou plus qui contient une combinaison qui est mutuellement capable de former un composé intermétallique.

10. Film adhésif électriquement conducteur selon la revendication 9, dans lequel au moins deux métaux dans les deux ou plusieurs métaux sont choisis parmi Cu, Ag, Ni, Ti, Al, Sn, Zn, Au et In.

11. Film adhésif électriquement conducteur selon l'une quelconque des revendications 1 à 10, qui, lorsqu'il est observé par DSC (calorimétrie à balayage différentiel), a au moins un pic endothermique allant de 100 °C à 250 °C avant le frittage qui est non observé après frittage.

12. Film de liaison de matrice de découpe, qui est obtenu en collant le film adhésif électriquement conducteur selon l'une quelconque des revendications 1 à 11 avec un ruban adhésif sensible à la pression.
